# DEMANDE DE BREVET EUROPEEN

(11) **EP 4 383 958 A1**
(43) Date de publication de la demande: **12.06.2024**
(21) Numéro de dépôt: 23209278.3
(22) Date de dépôt: 11.11.2023
(51) Int. Cl.: H05K 1/03, H05K 3/22, H05K 3/28, H05K 1/11, H05K 1/18

(54) **PIÈCE COMPRENANT EN SURFACE UN FILM INTÉGRANT AU MOINS UN CIRCUIT ÉLECTRONIQUE IMPRIMÉ POURVU DE BORNES DE RACCORDEMENT, PROCÉDÉ DE RÉPARATION D'UNE TELLE PIÈCE ET PIÈCE AINSI RÉPARÉE**

(30) Priorité: 08.12.2022 FR 2212937
(71) Demandeur: Airbus SAS, 31700 Blagnac Cedex (FR); Airbus Defence and Space GmbH, 82024 Taufkirchen (DE)
(72) Inventeur: FRIEDBERGER, Alois, 82024 TAUFKIRCHEN (DE); LEFEBURE, Patrice, 31700 BLAGNAC (FR); PETIOT, Caroline, 31700 BLAGNAC (FR)
(74) Mandataire: Fantin, Laurent

(57) **Abrégé**

L'invention a pour objet une pièce comprenant un corps (32) ainsi qu'un film (34) rapporté sur une surface (S32) du corps (32) et intégrant un circuit électronique. Ce circuit électronique comprend au moins un composant électronique (42), des lignes conductrices (44) reliées au composant électronique (42) ainsi qu'au moins deux bornes de raccordement (46, 48) positionnées sur au moins une des lignes conductrices (44), chaque borne de raccordement (46, 48) présentant une section transversale, dans un plan parallèle à la surface (S32) du corps (32), supérieure à deux fois la section transversale d'une ligne conductrice (44). Grâce aux bornes de raccordement (46, 48) réparties sur le circuit électronique, il est possible de remplacer un tronçon de circuit défectueux par un tronçon de circuit de réparation (56). L'invention a également pour objet un procédé de réparation d'une telle pièce ainsi que la pièce ainsi réparée.

## Description

La présente demande se rapporte à une pièce comprenant en surface un film intégrant au moins un circuit électronique imprimé pourvu de bornes de raccordement, à un procédé de réparation d'une telle pièce ainsi qu'à une pièce ainsi réparée.

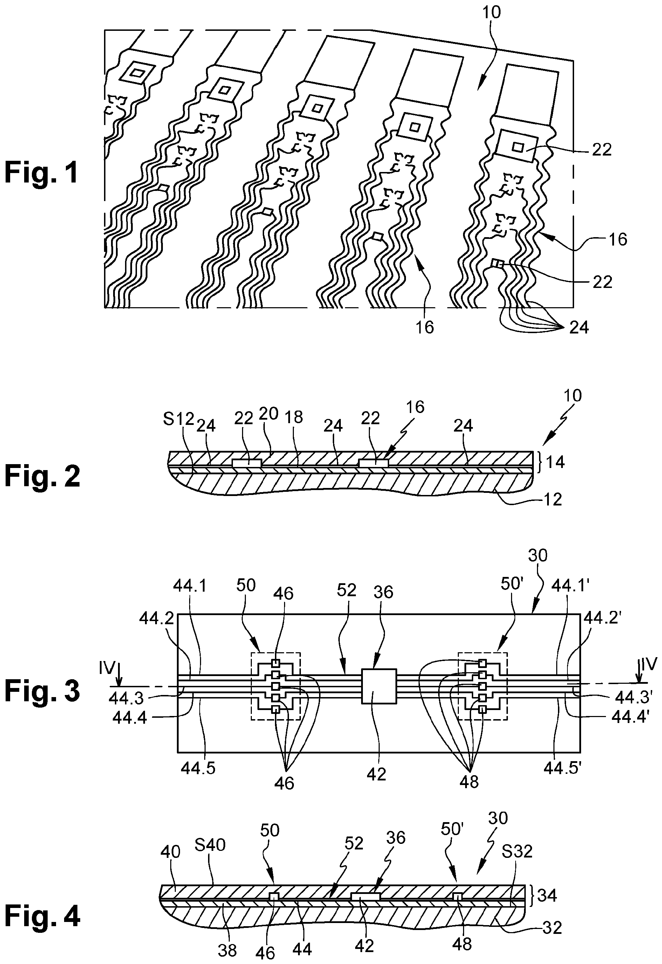

Selon un mode de réalisation visible sur les figures 1 et 2, une pièce 10 comprend un corps 12 en matériau composite ainsi qu'un film 14, rapporté sur la surface S12 du corps 12, intégrant au moins un circuit électronique 16. Le film 14 comprend une couche support 18 rapportée sur la surface S12 du corps 12, le circuit électronique 16 imprimé sur la couche support 18 ainsi qu'une couche de protection 20 recouvrant la couche support 18 et le circuit électronique 16.

Selon une configuration, le circuit électronique 16 comprend au moins un composant électronique 22, comme un capteur de température, de pression ou autres, ainsi que des lignes conductrices 24 formant un réseau d'éléments conducteurs. Comme illustré sur la figure 1, chaque ligne conductrice 24 présente une section transversale la plus faible possible. Selon un agencement, plusieurs lignes conductrices 24 peuvent être positionnées les unes à côté des autres en étant faiblement espacées entre elles. Les lignes conductrices 24 sont imprimées sur la couche support 18 par sérigraphie par exemple.

La pièce 10 peut être réalisée en utilisant des techniques de plastronique.

Même si la couche de protection 20 permet de protéger le circuit électronique 16, dans certaines circonstances le circuit électronique 16 peut être endommagé et certaines fonctionnalités peuvent ne plus fonctionner.

Dans de telles circonstances, une solution consiste à remplacer la pièce 10 par une nouvelle pièce non endommagée.

Cette solution n'est pas optimale car elle peut être coûteuse en raison du prix élevé de la pièce 10 et conduit dans tous les cas à générer des déchets (la pièce changée) qui doivent être traités. De plus, pour certaines applications, un tel changement n'est pas possible ou difficilement envisageable.

La présente invention vise à remédier à tout ou partie des inconvénients de l'art antérieur. A cet effet, l'invention a pour objet une pièce comprenant un corps présentant une surface ainsi qu'un film rapporté sur la surface du corps et intégrant un circuit électronique, ce dernier présentant une cartographie et comportant au moins un composant électronique ainsi que des lignes conductrices reliées au composant électronique, chaque ligne conductrice présentant une première section transversale dans un plan parallèle à la surface du corps. Selon l'invention, le circuit électronique comprend au moins deux bornes de raccordement positionnées sur au moins une des lignes conductrices et dans au moins une zone de raccordement, chaque borne de raccordement présentant une deuxième section transversale, dans un plan parallèle à la surface du corps, supérieure à deux fois la première section transversale d'une ligne conductrice. En complément, la zone de raccordement est sécante avec plusieurs lignes conductrices et comprend pour chacune d'elle une borne de raccordement, les bornes de raccordement étant plus espacées que les lignes conductrices de manière à pouvoir coopérer avec un système de raccordement d'un tronçon de circuit de réparation.

Grâce aux bornes de raccordement, il est possible de remplacer un tronçon de circuit défectueux par un tronçon de circuit de réparation. Ainsi, une pièce comportant en surface un film intégrant un circuit électronique imprimé peut être réparée sans avoir besoin d'être intégralement changée.

Selon une autre caractéristique, le circuit électronique comprend plusieurs zones de raccordement, comportant chacune au moins une borne de raccordement, réparties sur le circuit électronique et permettant d'isoler entre elles des tronçons de circuit.

L'invention a également pour objet un procédé de réparation d'une pièce selon l'une des caractéristiques précédentes. Ce procédé comprend une étape de détection et/ou de localisation d'un défaut, une étape d'identification, pour chaque défaut détecté, d'un tronçon de circuit défectueux intégrant le défaut détecté et, connaissant la cartographie du circuit électronique, des première et deuxième bornes de raccordement de chaque tronçon de circuit défectueux identifié ainsi que, pour chaque tronçon de circuit défectueux identifié, une étape de mise en place d'un tronçon de circuit de réparation relié aux première et deuxième bornes de raccordement situées aux extrémités du tronçon de circuit défectueux identifié, chaque tronçon de circuit de réparation comportant à ses extrémités des premier et deuxième systèmes de raccordement configurés pour coopérer avec les première et deuxième bornes de raccordement.

Selon une autre caractéristique, le procédé comprend une étape de retrait d'une partie d'une couche de protection recouvrant chacune des première et deuxième bornes de raccordement identifiées.

Selon une autre caractéristique, l'étape de mise en place de chaque tronçon de circuit de réparation consiste à utiliser un module de réparation qui comprend un support supportant le tronçon de circuit de réparation ainsi que les premier et deuxième systèmes de raccordement, et à relier les premier et deuxième systèmes de raccordement du module de réparation aux première et deuxième bornes de raccordement.

Selon une autre caractéristique, le support du module de réparation est une bande de textile, le tronçon de circuit de réparation comprenant des fils conducteurs souples intégrés dans la bande textile.

Selon une autre caractéristique, le module de réparation comprend au moins un système chauffant.

Selon une autre caractéristique, le système chauffant est une feuille métallique recouvrant le tronçon de circuit de réparation.

Enfin, l'invention a également pour objet une pièce réparée à partir du procédé de réparation selon l'une des caractéristiques précédentes.

D'autres caractéristiques et avantages ressortiront de la description de l'invention qui va suivre, description donnée à titre d'exemple uniquement, en regard des dessins annexés parmi lesquels :
- La figure 1 est une vue en perspective d'une pièce comportant en surface un film intégrant un circuit électronique imprimé illustrant un mode de réalisation de l'art antérieur,
- La figure 2 est une coupe de la pièce visible sur la figure 1,
- La figure 3 est une vue de dessus d'une pièce comportant en surface un film intégrant un circuit électronique imprimé et des zones de raccordement illustrant un mode de réalisation de l'invention,
- La figure 4 est une coupe selon la ligne IV-IV de la figure 3 d'une pièce comportant en surface un film intégrant un circuit électronique imprimé et des zones de raccordement illustrant un mode de réalisation de l'invention,
- La figure 5 est une coupe de la pièce visible sur la figure 4 après une étape de retrait d'une partie d'une couche de protection au droit des zones de raccordement illustrant un mode de réalisation de l'invention,
- La figure 6 est une coupe de la pièce visible sur la figure 5 après une étape de mise en place d'un tronçon de circuit de réparation illustrant un mode de réalisation de l'invention,
- La figure 7 est une vue en perspective d'une pièce comportant un tronçon de circuit de réparation illustrant une première configuration de l'invention,
- La figure 8 est une vue en perspective d'une pièce comportant deux tronçons de circuit de réparation illustrant une autre configuration de l'invention,
- La figure 9 est une coupe d'une zone de raccordement illustrant un mode de réalisation de l'invention,
- La figure 10 est une coupe d'une zone de raccordement illustrant un autre mode de réalisation de l'invention,
- La figure 11 est une vue en perspective d'un module de réparation illustrant un mode de réalisation de l'invention,
- La figure 12 est une représentation schématique d'une partie d'un circuit électronique illustrant un premier agencement de l'invention, et
- La figure 13 est une représentation schématique d'une partie d'un circuit électronique illustrant un autre agencement de l'invention.

Selon un mode de réalisation visible sur les figures 3 et 4, une pièce 30 comprend un corps 32 présentant une surface S32 ainsi qu'un film 34, rapporté sur la surface S32 du corps 32, intégrant au moins un circuit électronique 36.

Selon une configuration, le corps 32 est en matériau composite ou en matière plastique. La surface S32 peut être plane, comme illustré sur la figure 4, ou courbe.

Le film 34 comprend une couche support 38 fixée sur la surface S32 du corps 32, le circuit électronique 36 rapporté sur la couche support 38 ainsi qu'une couche de protection 40 recouvrant au moins partiellement la couche support 38 et le circuit électronique 36.

Selon une configuration, le circuit électronique 36 présente une cartographie et comprend au moins un composant électronique 42, comme un capteur de température, de pression ou autres, ainsi que des lignes conductrices 44 reliées au composant électronique 42 et présentant une première section transversale dans un plan parallèle à la surface S32 du corps 32. La couche de protection 40 présente une surface libre S40 distante des composants électroniques 42 et des lignes conductrices 44.

Comme illustré sur la figure 3, chaque ligne conductrice 44 présente une première section transversale réduite. Selon un agencement, plusieurs lignes conductrices 44 peuvent être positionnées les unes à côté des autres en étant faiblement espacées entre elles. Selon un mode opératoire, les lignes conductrices 44, 44.1 à 44.5, 44.1' à 44.5' sont imprimées sur la couche support 38 par sérigraphie par exemple.

Le corps 32, la couche support 38, la couche de protection 40, les composants électroniques 42 et les lignes conductrices 44 ne sont pas plus décrits car ils peuvent être identiques à ceux de l'art antérieur.

Selon une application, un aéronef comprend au moins une pièce 30, comme illustré sur les figures 3 et 4.

Selon une particularité de l'invention, le circuit électronique 36 comprend au moins deux bornes de raccordement 46, 48 positionnées sur au moins une des lignes conductrices 44 et dans au moins une zone de raccordement 50, 50'.

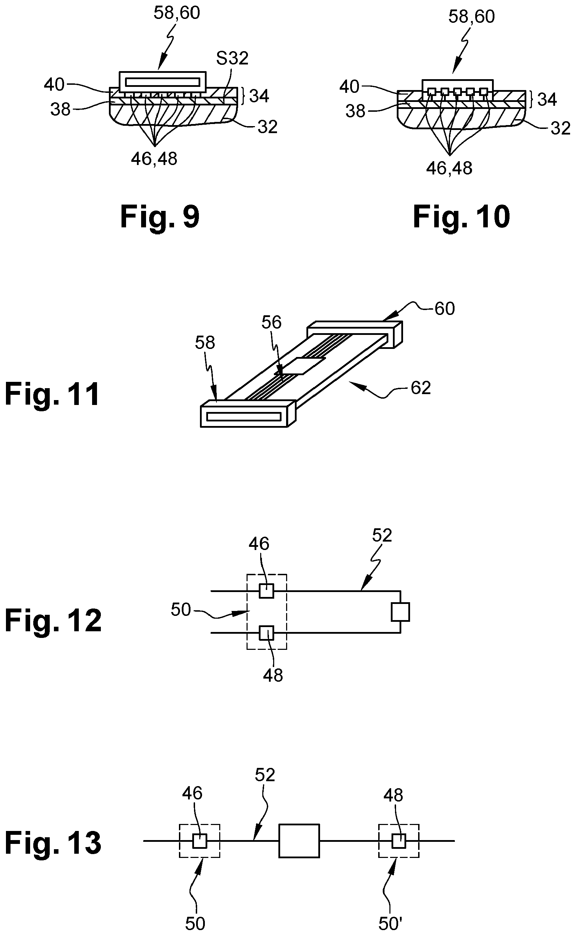

Selon un premier agencement visible sur la figure 12, les deux bornes de raccordement 46, 48 sont positionnées dans la même zone de raccordement 50, un tronçon de circuit 52 étant isolé entre les deux bornes de raccordement 46, 48.

Selon un deuxième agencement visible sur la figure 13, les deux bornes de raccordement 46, 48 sont positionnées dans deux zones de raccordement 50, 50' distinctes, un tronçon de circuit 52 étant isolé entre les deux bornes de raccordement 46, 48.

Selon une configuration, le circuit électronique 36 comprend plusieurs zones de raccordement 50, 50', comportant chacune au moins une borne de raccordement 46, 48, réparties sur le circuit électronique 36 et permettant d'isoler entre elles des tronçons de circuit 52.

Selon un agencement visible sur la figure 3, le circuit électronique 36 comprend cinq lignes conductrices amont 44.1 à 44.5 positionnés en amont d'un tronçon de circuit 52, cinq lignes conductrices aval 44.1' à 44.5' positionnés en aval du tronçon de circuit 52, une première zone de raccordement 50 sécante avec les cinq lignes conductrices amont 44.1 à 44.5 comprenant pour chacune d'elles une borne de raccordement 46 amont ainsi qu'une deuxième zone de raccordement 50' sécante avec les cinq lignes conductrices aval 44.1' à 44.5' comprenant pour chacune d'elles une borne de raccordement 48 aval.

Quel que soit le mode de réalisation, chaque borne de raccordement 46, 48 présente une deuxième section transversale, dans un plan parallèle à la surface S32 du corps 32, supérieure à deux fois la première section transversale d'une ligne conductrice 44 pour permettre un raccordement. Cette configuration permet de pouvoir raccorder aux bornes de raccordement 46, 48 un instrument externe ou un tronçon de circuit de réparation par exemple. A titre indicatif, chaque borne de raccordement 46, 48 se présente, en vue de dessus, sous la forme d'un carré avec un côté supérieur ou égal à 1 mm, de préférence de l'ordre de 2 mm, ou d'un cercle avec un diamètre supérieur ou égal 1 mm, de préférence de l'ordre de 2 mm.

De plus, lorsque la zone de raccordement 50, 50' est sécante avec plusieurs lignes conductrices et comprend pour chacune d'elles une borne de raccordement 46, 48, les différentes bornes de raccordement 46, 48 sont plus espacées que les lignes conductrices 44 pour faciliter le raccordement d'un instrument externe ou d'un tronçon de circuit de réparation.

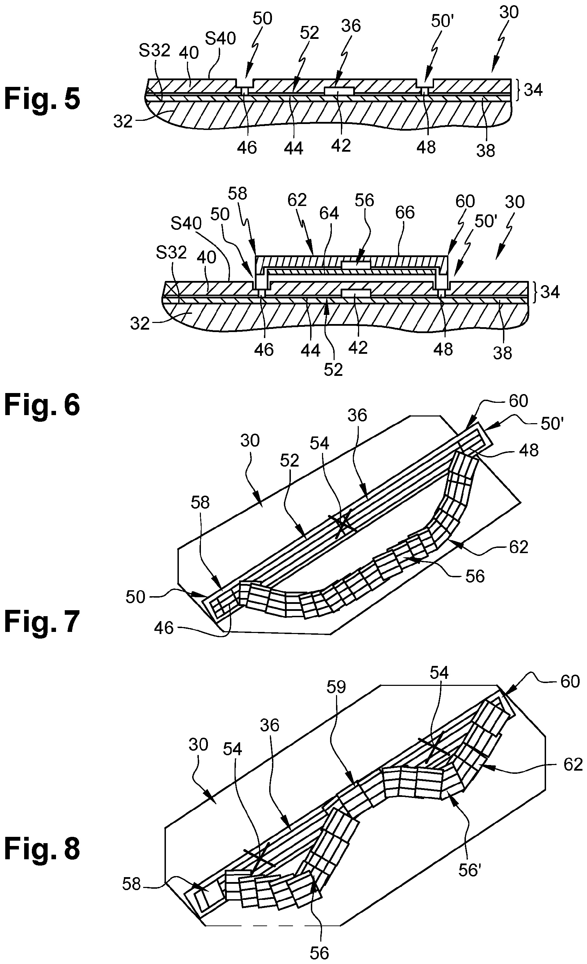

Selon un mode de réalisation, les bornes de raccordement 46, 48 présentent une épaisseur adaptée de sorte qu'elles affleurent à la surface libre S40 de la couche de protection. En variante, les bornes de raccordement 46, 48 sont recouvertes par la couche de protection 40. En fonctionnement, le circuit électronique 36 peut comprendre au moins un défaut 54 comme une coupure d'une ligne conductrice et/ou un court-circuit par exemple, comme illustré sur la figure 7.

Selon un mode opératoire, un procédé de réparation dudit circuit électronique 36 comprend une étape de détection et/ou de localisation du défaut 54. Selon un premier mode de réalisation, le circuit électronique 36 est configuré pour réaliser un autotest afin de détecter et/ou de localiser le défaut 54. Selon un deuxième mode de réalisation, un équipement externe de détection et/ou de localisation, distinct du circuit électronique 36, est utilisé pour détecter et/ou localiser le défaut 54. Au moins une zone de raccordement 50, 50' peut être utilisée pour raccorder l'équipement externe au circuit électronique 36 afin de réaliser l'étape de détection et/ou de localisation. A cet effet, les parties positionnées au-dessus des zones de raccordement 50, 50' sont retirées pour dégager les bornes de raccordement 46, 48 si ces dernières sont recouvertes par la couche de protection 40.

Selon les premier et deuxième modes de réalisation, l'étape de détection et/ou de localisation du défaut 54 comprend une méthode de diagnostic par réflectométrie.

A la suite de l'étape de détection et/ou de localisation, le procédé de réparation comprend une étape d'identification, pour chaque défaut détecté, du tronçon de circuit 52 l'intégrant et, connaissant la cartographie du circuit électronique 36, des première et deuxième bornes de raccordement 46, 48 de chaque tronçon de circuit 52 identifié et de la (ou des) zone(s) de raccordement 50, 50' correspondante(s).

Si les bornes de raccordement 46, 48 sont recouvertes par la couche de protection 40, le procédé de réparation comprend une étape de retrait d'une partie de la couche de protection 40 située au-dessus de chacune des première et deuxième bornes de raccordement 46, 48 identifiées, comme illustré sur la figure 5. Selon un mode de réalisation, un faisceau laser est utilisé pour réaliser ce retrait. A titre d'exemple, une source laser portable est utilisée, notamment une source laser intégrant de préférence une diode pulsée et émettant un faisceau laser de type UV qui présente une largeur d'impulsion comprise entre 1 et 100 ns. Bien entendu, l'invention n'est pas limitée à ce mode de réalisation pour le faisceau laser. Ce dernier est notamment choisi en fonction de la nature de la couche de protection 40.

Lors de l'étape de retrait, un système de mesure de la profondeur de la matière retirée, comme un système spectroscopique par exemple, peut être utilisé pour déterminer lorsque le retrait de matière est suffisant afin de dégager les première et deuxième bornes de raccordement 46, 48.

Selon une configuration, la couche de protection 40 comprend au moins un marquage délimitant au moins une zone de raccordement 50, 50' pour faciliter son repérage, notamment lorsque la couche de protection 40 est opaque. Selon une configuration, la couche de protection 40 comprend un marquage pour chaque zone de raccordement 50, 50'.

Après l'étape de retrait, le procédé de réparation comprend une étape de mise en place d'un tronçon de circuit de réparation 56, comme illustré sur la figure 6, relié aux première et deuxième bornes de raccordement 46, 48 situées aux extrémités du tronçon de circuit 52 défectueux. Selon une configuration, le tronçon de circuit de réparation 56 est identique au tronçon de circuit 52 et comprend les mêmes composants électroniques 42 et les mêmes lignes conductrices 44 que le tronçon de circuit 52 défectueux.

Le tronçon de circuit de réparation 56 comprend à ses extrémités des premier et deuxième systèmes de raccordement 58, 60 configurés pour coopérer avec les première et deuxième bornes de raccordement 46, 48.

Selon un mode de réalisation visible sur la figure 9, les premier et deuxième systèmes de raccordement 58, 60 sont collés sur les première et deuxième bornes de raccordement 46, 48. En variante, les premier et deuxième systèmes de raccordement 58, 60 peuvent être maintenus en contact contre les première et deuxième bornes de raccordement 46, 48 par d'autres systèmes de maintien, comme des clips, des agrafes ou autres par exemple.

Selon un autre mode de réalisation visible sur la figure 10, la première (ou deuxième) borne de raccordement 46 (ou 48) et le premier (ou deuxième) système de raccordement 58 (ou 60) sont configurés pour coopérer entre eux et former les parties mâle et femelle d'un système de connexion.

Selon un mode de réalisation, l'étape de mise en place de chaque tronçon de circuit de réparation 56 consiste à utiliser un module de réparation 62, comprenant un support 64 configuré pour supporter le tronçon de circuit de réparation 56 ainsi que les premier et deuxième systèmes de raccordement 58, 60, et à relier les premier et deuxième systèmes de raccordement 58, 60 du module de réparation 62 aux première et deuxième bornes de raccordement 46, 48.

Selon une configuration visible sur les figures 6 et 7, un module de réparation 62 comprend un unique tronçon de circuit de réparation 56 et deux systèmes de raccordement 58, 60.

Selon une autre configuration visible sur la figure 8, un module de réparation 62 comprend plusieurs tronçons de circuit de réparation 56, 56' comportant chacun deux systèmes de raccordement 58, 59, 60, un système de raccordement 59 étant commun aux deux tronçons de circuit de réparation 56, 56'.

Quel que soit le mode de réalisation, le module de réparation 62 comprend au moins un tronçon de circuit de réparation 56 et au moins deux systèmes de raccordement 58, 60.

Le module de réparation 62 peut comprendre une couche de protection 66 recouvrant chaque tronçon de circuit de réparation 56, 56'.

Le support 64 peut être rigide ou flexible. Selon une configuration, le support 64 se présente sous la forme d'une bande textile souple et le tronçon de circuit de réparation 56 comprend des fils conducteurs souples intégrés dans la bande textile.

Selon une configuration, l'étape de mise en place de chaque tronçon de circuit de réparation 56 comprend une phase de polymérisation du module de réparation 62. Selon un mode de réalisation, le module de réparation 62 est auto-polymérisable et comprend au moins un système chauffant. Selon une conception, le système chauffant est une feuille métallique, perforée ou non, recouvrant le tronçon de circuit de réparation 56, 56'. Ainsi, cette feuille métallique assure la fonction d'élément chauffant lorsqu'elle est parcourue par un courant électrique mais également la fonction de protection mécanique, la fonction de protection contre la foudre, la fonction de couche de masse électrique et/ou la fonction de couche de blindage.

Selon un mode de réalisation, le module de réparation 62 comprend au moins un système d'étanchéité au droit d'au moins un système de raccordement 58, 60. Ce système d'étanchéité peut comprendre un matériau partiellement fusible à la température de polymérisation du module de réparation 62 ou à la température de collage des systèmes de raccordement 58, 60.

Grâce aux bornes de raccordement 46, 48 réparties sur le circuit électronique 36, il est possible de remplacer un tronçon de circuit 52 défectueux par un tronçon de circuit de réparation 56. Ainsi, une pièce comportant en surface un film intégrant un circuit électronique 36 imprimé peut être réparée sans avoir besoin d'être intégralement changée.

## Revendications

1. Pièce comprenant un corps (32) présentant une surface (S32) ainsi qu'un film (34) rapporté sur la surface (S32) du corps (32) et intégrant un circuit électronique (36), ce dernier présentant une cartographie et comportant au moins un composant électronique (42) ainsi que des lignes conductrices (44) reliées au composant électronique (42), chaque ligne conductrice (44) présentant une première section transversale dans un plan parallèle à la surface (S32) du corps (32) ; **caractérisée en ce que** le circuit électronique (36) comprend au moins deux bornes de raccordement (46, 48) positionnées sur au moins une des lignes conductrices (44) et dans au moins une zone de raccordement (50, 50'), chaque borne de raccordement (46, 48) présentant une deuxième section transversale, dans un plan parallèle à la surface (S32) du corps (32), supérieure à deux fois la première section transversale d'une ligne conductrice (44) et **en ce que** la zone de raccordement (50, 50') est sécante avec plusieurs lignes conductrices (44) et comprend pour chacune d'elle une borne de raccordement (46, 48), les bornes de raccordement (46, 48) étant plus espacées que les lignes conductrices (44) de manière à pouvoir coopérer avec un système de raccordement (58, 60) d'un tronçon de circuit de réparation (56).

2. Pièce selon la revendication 1, **caractérisée en ce que** le circuit électronique (36) comprend plusieurs zones de raccordement (50, 50') comportant chacune au moins une borne de raccordement (46, 48), réparties sur le circuit électronique (36) et permettant d'isoler entre elles des tronçons de circuit (52).

3. Procédé de réparation d'une pièce selon l'une des revendications précédentes, **caractérisé en ce que** le procédé comprend une étape de détection et/ou de localisation d'un défaut (54), une étape d'identification, pour chaque défaut (54) détecté, d'un tronçon de circuit (52) défectueux intégrant le défaut (54) détecté et, connaissant la cartographie du circuit électronique (36), des première et deuxième bornes de raccordement (46, 48) de chaque tronçon de circuit (52) défectueux identifié ainsi que, pour chaque tronçon de circuit (52) défectueux identifié, une étape de mise en place d'un tronçon de circuit de réparation (56) relié aux première et deuxième bornes de raccordement (46, 48) situées aux extrémités du tronçon de circuit (52) défectueux identifié, chaque tronçon de circuit de réparation (56) comportant à ses extrémités des premier et deuxième systèmes de raccordement (58, 60) configurés pour coopérer avec les première et deuxième bornes de raccordement (46, 48).

4. Procédé selon la revendication précédente, **caractérisé en ce qu'**il comprend une étape de retrait d'une partie d'une couche de protection (40) recouvrant chacune des première et deuxième bornes de raccordement (46, 48) identifiées.

5. Procédé de réparation selon la revendication précédente, **caractérisé en ce que** l'étape de mise en place de chaque tronçon de circuit de réparation (56) consiste à utiliser un module de réparation (62), comprenant un support (64) supportant le tronçon de circuit de réparation (56) ainsi que les premier et deuxième systèmes de raccordement (58, 60), et à relier les premier et deuxième systèmes de raccordement (58, 60) du module de réparation (62) aux première et deuxième bornes de raccordement (46, 48).

6. Procédé de réparation selon la revendication précédente, **caractérisé en ce que** le support (64) du module de réparation (64) est une bande de textile, le tronçon de circuit de réparation (56) comprenant des fils conducteurs souples intégrés dans la bande textile.

7. Procédé de réparation selon la revendication 5 ou 6, **caractérisé en ce que** le module de réparation (62) comprend au moins un système chauffant.

8. Procédé de réparation selon la revendication précédente, **caractérisé en ce que** le système chauffant est une feuille métallique recouvrant le tronçon de circuit de réparation (56).

9. Pièce réparée à partir du procédé de réparation selon l'une des revendications 3 à 8.
